**Europäisches Patentamt**

**European Patent Office**

**Office européen des brevets**

(11) Publication number : **0 512 731 A1**

## (12) EUROPEAN PATENT APPLICATION

(21) Application number : **92303808.7**

(22) Date of filing : **28.04.92**

(51) Int. Cl.$^5$ : **H03F 3/45**

(30) Priority : **09.05.91 GB 9110023**

(43) Date of publication of application :
**11.11.92 Bulletin 92/46**

(84) Designated Contracting States :
**DE ES FR GB IT**

(71) Applicant : **LUCAS INDUSTRIES PUBLIC LIMITED COMPANY**
**Brueton House, New Road**
**Solihull, West Midlands B91 3TX (GB)**

(72) Inventor : **Swindell, David Francis**
**22, Caldeford Avenue, Monkspath**
**Solihull, West Midlands, B90 4UD (GB)**

(74) Representative : **Robinson, John Stuart et al**
**Marks & Clerk Alpha Tower Suffolk Street**
**Queensway**
**Birmingham, B1 1TT (GB)**

(54) **Voltage-to-current converter.**

(57)   A voltage to current converter is provided having a differential operational amplifier (1), a current source (2) and feed back components (5, 7). The current supplied to a load (10) is proportional to a voltage difference between first and second inputs of the converter.

FIG 2

The present invention relates to a voltage-to-current converter (VCC), for instance for converting an output voltage of a sensor arrangement to a corresponding current.

According to a first aspect of the invention, there is provided a voltage-to-current converter, comprising a differential amplifier having differential inputs and a current generator having an input connected to an output of the amplifier and a current sensing resistor connected to an inverting input node of the amplifier.

According to a second aspect of the invention, there is provided a voltage-to-current converter, comprising:

a differential amplifier having an inverting input connected via a first resistor to a first input terminal and a non-inverting input connected via a second resistor to a second input terminal;

a transistor having a base connected to the output of the amplifier, an emitter connected via a third resistor to a power supply line, and a collector connected to an output of the converter;

a fourth resistor connected between the inverting input and the emitter; and

a fifth resistor connected between the non-inverting input and a common line.

Preferably the fifth resistor is connected between the non-inverting input and the power supply line.

The invention will be further described, by way of example, with reference to the accompanying drawings, in which:-

Figure 1 is a circuit diagram of a VCC constituting a first embodiment of the invention; and

Figure 2 is a circuit diagram of a VCC constituting a second embodiment of the invention.

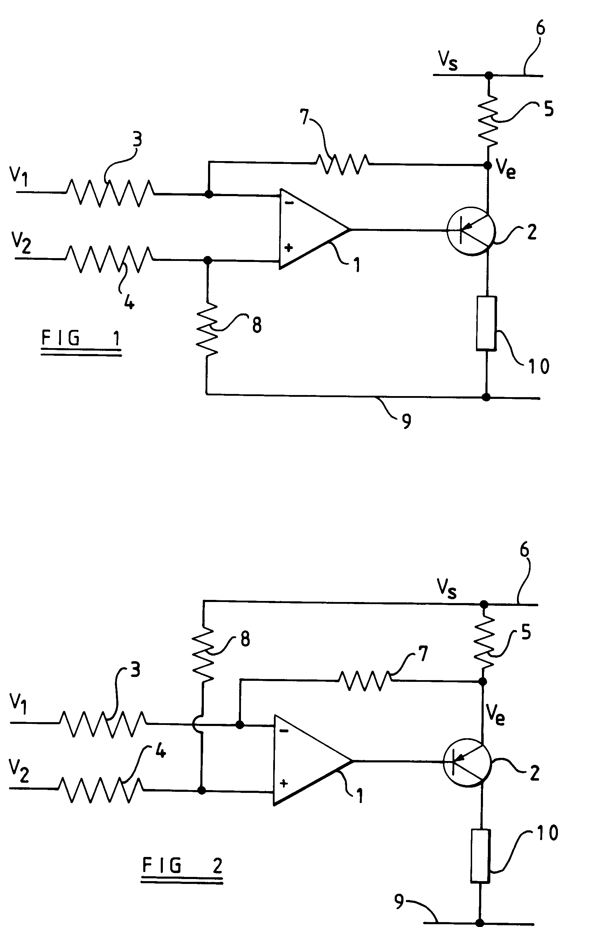

The VCC shown in Figure 1 comprises a differential amplifier 1, such as an operational amplifier, whose output is connected to the base of a PNP transistor 2. The inverting and non-inverting inputs of the amplifier 1 are connected via first and second resistors 3 and 4 to inverting and non-inverting inputs, respectively, of the converter. The emitter of the transistor 2 is connected via a third resistor 5 to a positive supply line 6 and via a fourth resistor 7 to the inverting input of the amplifier 1. The non-inverting input of the amplifier 1 is connected via a fifth resistor 8 to a negative supply line 9. The collector of the transistor 2 forms an output terminal of the converter and is connected to a first terminal of a load 10 whose second terminal is connected to the negative supply line 9.

The values of the resistors 3 and 4 are equal to each other and the values of the resistors 7 and 8 are equal to each other. Preferably, the values of the resistors 3 and 4 are also equal to the values of the resistors 7 and 8. For this case where the resistors each have a value R1, the converter converts a differential input voltage to a single-ended output current as follows.

Because of the feedback provided by the resistor 7, the voltage Ve at the emitter of the transistor 2 is equal to (V2-V1), where V1 and V2 are the input voltages applied to the inverting and the non-inverting inputs, respectively, of the converter. The voltage across the resistor R5 is equal to the difference between the positive supply voltage Vs and the emitter voltage Ve of the transistor 2 if the value of the resistor 5 is R2, then the current flowing into the emitter of the transistor 2 is equal to:

$$(Vs+V1-V2)/R2$$

In fact, the emitter current of the transistor 2 is less than this value by the amount of the current flowing through the resistor 7, but this current is sufficiently small, for a high gain operational amplifier 1, to be neglected. Typically, the value of the resistor 7 is much greater than that of the resistor 5. Assuming that the gain of the bipolar transistor is relatively high, the base current may be neglected so that the collector current, and hence the current supplied to the load 10, is substantially equal to the emitter current.

Thus, assuming that the supply voltage Vs is constant, the output current of the converter is proportional to the difference between the input voltages V1 and V2 and the constant of proportionality is equal to the reciprocal of the value of the resistor 5.

The value of the resistors 7 and 8 may be changed so as to alter the constant of proportionality. However, it is preferable for the values of the resistors 3, 4, 7, and 8 to be constant and equal to each other, and for the constant of proportionality to be altered by varying the value of the resistor 5.

The converter shown in Figure 1 has a current source output but, by reversing the polarities of the supply lines 6 and 9 and changing the transistor 2 to an NPN transistor, a current sink output may be provided.

By providing differential inputs, the converter is capable of providing good noise rejection where noise signals are present as a common mode input signal. The circuit exhibits good linearity of conversion from differential voltage to output current. Further, the circuit is capable of working with a limited supply voltage Vs, since it is capable of working close to the supply line voltages and can provide good current swings This converter is therefore well-suited to use as an output stage of a sensor arrangement for converting an output voltage proportional to a sensor voltage into a corresponding current.

As indicated above, the output current of the converter shown in Figure 1 is dependent on the supply voltage Vs, so that any variations in the supply voltage affect the output current of the converter. In order to avoid dependence on the supply voltage, the circuit shown in Figure 2 may be used. Like references refer to like parts, which will not be described again.

The converter of Figure 2 differs from that of Figure 1 in that the resistor 8 is connected between the non-inverting input of the amplifier 1 and the positive supply line 6. For the same resistor values as above, the operation of the VCC of Figure 2 is as follows.

The emitter voltage Ve of the transistor 2 is equal to:

$$Vs+V2-V1$$

so that the voltage across the resistor 5 is equal to:

$$V1-V2$$

The emitter current, and hence the collector current, of the transistor 2 is therefore equal to:

$$(V1-V2)/R2$$

and is therefore substantially independent of the power supply voltage Vs.

Again, the converter of Figure 2 provides a current source output but may be changed to provide a current sink output by reversing the polarities of the supply lines 6 and 9 and changing the transistor 2 to a NPN transistor.

The load 10 is shown in Figures 1 and 2 as having its second terminal connected to the power supply line 9 of the VCC. However, the second terminal of the load may be connected to a different power supply line. Reverse-polarity protection may be provided by means of a normally reverse-biassed diode.

Although the transistor 2 in Figures 1 and 2 is shown as a bipolar transistor, it is possible to use a field effect transistor.

## Claims

1. A voltage to current converter, comprising a differential amplifier (1) having differential inputs, a current generator (2) having an input connected to an output of the amplifier (1), and a current sensing resistor (5) connected to an inverting input node of the amplifier, characterised in that the converter has first (V1) and second (V2) differential input terminals connected to the differential inputs of the differential amplifier.

2. A voltage to current converter as claimed in claim 1, characterised in that:
   the differential amplifier (1) has an inverting input (-) connected via a first resistor (3) to the first input terminal (V1) and a non-inverting input (+) connected via a second resistor (4) to the second input terminal (V2);
   the current generator has a supply terminal connected via the current sensing resistor (5) to a power supply line and an output terminal connected to an output of the converter;
   a third resistor (7) is connected between the inverting input (-) and the supply terminal; and
   a fourth resistor (8) is connected between the non-inverting input (+) and a common line (6,9).

3. A voltage to current converter as claimed in claim 2, characterised in that the common line is the power supply line (6).

4. A voltage to current converter as claimed in claim 2, characterised in that the common line is a ground line (9).

5. A voltage to current converter as claimed in any one of claims 2 to 4, characterised in that the current generator (2) is a bipolar transistor, the input of the current generator is a base of the transistor, the supply terminal is an emitter of the transistor and the output terminal is a collector of the transistor.

6. A voltage to current converter as claimed in any one of claims 2 to 4, characterised in that the current generator (2) is a field effect transistor, the input of the current generator is a gate of the transistor, the supply terminal is a source of the transistor and the output terminal is a drain of the transistor.

7. A voltage to current converter as claimed in any one of claims 2 to 6, characterised in that the first, second, third and fourth resistors (3,4,7,8) have equal resistances.

FIG 1

FIG 2

**European Patent Office**

# EUROPEAN SEARCH REPORT

Application Number

EP    92 30 3808

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | DE-A-3 432 561 (C.A. WEIDMÜLLER GMBH & CO) <br> * abstract; figures 1,2 * <br> * page 4, line 9 - line 17 * | 1-5 | H03F3/45 |
| | ----- | | |
| | | | **TECHNICAL FIELDS SEARCHED (Int. Cl.5 )** <br><br> H03F <br> G05F |

The present search report has been drawn up for all claims

| Place of search | Date of completion of the search | Examiner |
|---|---|---|
| BERLIN | 06 AUGUST 1992 | DANIELIDIS S. |